# EUROPEAN PATENT APPLICATION

(11) **EP 3 872 567 A1**
(43) Date of publication of application: **01.09.2021**
(21) Application number: 20159192.2
(22) Date of filing: 25.02.2020
(51) Int. Cl.: G03F 7/20, G05B 19/418

(54) **SYSTEMS AND METHODS FOR PROCESS METRIC AWARE PROCESS CONTROL**

(71) Applicant: ASML Netherlands B.V., 5500 AH Veldhoven (NL)
(72) Inventor: LARRANAGA, Maialen, 5500 AH Veldhoven (NL); GKOROU, Dimitra, 5500 AH Veldhoven (NL); YPMA, Alexander, 5500 AH Veldhoven (NL)
(74) Representative: ASML Netherlands B.V.

(57) **Abstract**

Described herein is a model free reinforcement learning system and method for determining a relationship between sequences of states of a wafer across multiple process steps and process yield for the wafer. The system and method are configured such that an optimal policy (e.g. sequence of through stack actions) is defined which produces optimum wafer yield and/or a lowest cost (in view of metrology time for example) processing process.

## Description

### TECHNICAL FIELD

The description herein relates to a system and method for process metric aware process control.

### BACKGROUND

Integrated circuit manufacturing may include various processes such as lithography, etching, deposition, chemical mechanical polishing, ion implantation, and/or other operations. Individual operations may yield parts that meet manufacturing specifications, or parts that are rejected for not meeting these specifications. Corrections to a manufacturing operation may be made based on whether a part meets manufacturing specifications, for example.

A lithographic projection apparatus can be used, for example, in the manufacture of integrated circuits (ICs). In such a case, a patterning device (e.g., a mask) may contain or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatus, the pattern on the entire patterning device is transferred onto one target portion in one operation. Such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively. Since, in general, the lithographic projection apparatus will have a reduction ratio M (e.g., 4), the speed F at which the substrate is moved will be 1/M times that at which the projection beam scans the patterning device. More information with regard to lithographic devices as described herein can be gleaned, for example, from US 6,046,792, incorporated herein by reference.

Prior to transferring the pattern from the patterning device to the substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish an individual layer of the device. If several layers are required in the device, then the whole procedure, or a variant thereof, is repeated for each layer. Eventually, a device will be present in each target portion on the substrate. These devices are then separated from one another by a technique such as dicing or sawing. Individual devices can be mounted on a carrier, connected to pins, etc.

Manufacturing semiconductor devices typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc. One or more metrology processes are also typically involved in the patterning process.

As noted, lithography is a central step in the manufacturing of device such as ICs, where patterns formed on substrates define functional elements of the devices, such as microprocessors, memory chips, etc. Similar lithographic techniques are also used in the formation of flat panel displays, micro-electro mechanical systems (MEMS) and other devices.

As semiconductor manufacturing processes continue to advance, the dimensions of functional elements have continually been reduced while the number of functional elements, such as transistors, per device has been steadily increasing over decades, following a trend commonly referred to as "Moore's law". At the current state of technology, layers of devices are manufactured using lithographic projection apparatuses that project a design layout onto a substrate using illumination from a deep-ultraviolet illumination source, and/or an extreme ultraviolet illumination source, creating individual functional elements having dimensions well below 100 nm, i.e. less than half the wavelength of the radiation from the illumination source.

This process in which features with dimensions smaller than the classical resolution limit of a lithographic projection apparatus are printed, is commonly known as low-ki lithography, according to the resolution formula CD = k₁×λ/NA, where λ is the wavelength of radiation employed (currently in most cases 248nm or 193nm), NA is the numerical aperture of projection optics in the lithographic projection apparatus, CD is the "critical dimension"-generally the smallest feature size printed-and k₁ is an empirical resolution factor. In general, the smaller k₁ the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but not limited to, optimization of NA and optical coherence settings, customized illumination schemes, use of phase shifting patterning devices, optical proximity correction (OPC, sometimes also referred to as "optical and process correction") in the design layout, or other methods generally defined as "resolution enhancement techniques" (RET).

### SUMMARY

Corrections and/or other adjustments to layers on a wafer are typically based on information from an immediately previous layer of the wafer. Often, there is no through (wafer) stack yield optimization. Advantageously, the present system and method use model free reinforcement learning to determine a relationship between sequences of states of a wafer and a final yield for the wafer and make corrections and/or other adjustments that optimize the yield and/or processing time and/or costs.

According to an embodiment, there is provided a semiconductor processing method. The method comprises determining, with one or more processors, a sequence of states of a processed object. The states are determined based on processing information associated with the object. The method comprises determining, with the one or more processors, based on at least one of the states within the sequence of states, a process metric associated with the object. The process metric comprises an indication of whether processing requirements for the object are satisfied for individual states in the sequence of states. The method comprises initiating, with the one or more processors, an adjustment to the processing process based on (1) at least one of the states within the sequence of states and (2) the process metric. The adjustment is configured to enhance the process metric for the individual states in the sequence of states such that final processing requirements for the object are satisfied.

In an embodiment, the sequence of states corresponds to a sequence of processing operations performed for the object. Determining the sequence of states, determining the process metric, and initiating the adjustment comprises: determining a policy function, P(s), that defines processing operation corrections for individual states, equipment for performing the processing operations, and/or one or more process parameters for the processing operations; and/or determining a value function, V(s), that defines the enhancement of the process metric assuming the policy function is followed until completion of the sequence of processing operations.

In an embodiment, the value function defines an expected process metric for a given state (s).

In an embodiment, the method is performed for a semiconductor processing environment, and the processed object is a semiconductor wafer, or one or more portions of the semiconductor wafer.

In an embodiment, the process metric comprises one or more of yield, cost of senor measurements, throughput, an indication of a tradeoff between yield optimization and measurement density, cost of overlay measurements, or overlay.

In an embodiment, the process metric comprises a reward, and the one or more processors comprise an agent.

In an embodiment, the process metric comprises yield, and enhancing the process metric for the individual states in the sequence of states such that final processing requirements for the object are satisfied comprises increasing the yield.

In an embodiment, the process metric and/or the adjustment is determined based on at least two of the states within the sequence of states.

In an embodiment, the process metric and/or the adjustment is determined based on a plurality of the states within the sequence of states.

In an embodiment, initiating the adjustment comprises (1) optimizing the process metric based on the sequence of states, and determining the adjustment based on the optimized process metric; and/or (2) prompting a user to make the adjustment.

In an embodiment, the adjustment comprises a correction.

In an embodiment, the correction is an exposure correction associated with the semiconductor processing process.

In an embodiment, the adjustment comprises an indication of where, when, and/or how to measure the object during one or more processing operations.

In an embodiment, the sequence of states corresponds to a sequence of processing operations performed for the object, and the adjustment comprises one or more of a change in which processing operations are performed, a change in an order in which the processing operations are performed, or a change in one or more pieces of equipment used to perform one or more of the processing operations.

In an embodiment, the adjustment comprises a change in one or more process parameters of the one or more processing operations.

In an embodiment, the one or more process parameters comprise one or more of a dose, a focus, a mask design, an exposure level, one or more etch parameters, one or more deposition parameters, or one or more measurement parameters.

In an embodiment, the sequence of states corresponds to a sequence of processing operations performed for the object, and the processing information comprises one or more of values of measurements of the object performed as part of the processing operations, an indication of which processing operations were performed, an indication of an order of the sequence of processing operations, an indication of which equipment was used in the processing operations and/or associated machine constants, or processing parameters of the processing operations.

In an embodiment, determining the sequence of states, determining the process metric, and initiating the adjustment are performed as at least part of a model free reinforcement learning (MFRL) framework.

In an embodiment, the MFRL framework comprises one or more of an asynchronous advantage actor-critic algorithm, a Q-learning with normalized advantage function, a trust region policy optimization algorithm, a proximal policy optimization algorithm, a twin delayed deep deterministic policy gradient, or a soft actor-critic algorithm.

In an embodiment, the sequence of states includes one or more future states of the object, determining the process metric is based on the sequence of states including the one or more future states; and initiating the adjustment to the processing process is based on the sequence of states, including the one or more futures states, and the process metric.

In an embodiment, the method further comprises comparing, with the one or more processors, a first sequence of one or more processing operations having first process parameters to a second sequence of one or more processing operations having second process parameters based on policy functions and value functions associated with the first and second sequences.

In an embodiment, the method further comprises performing the determining of the sequence of states, the determining of the process metric, and the initiating of the adjustment as part of a serving operational phase; and prior to the serving phase, training the policy function and/or the value function during a training operational phase.

In an embodiment, the training operational phase is performed in a simulated semiconductor processing environment.

According to another embodiment, there is provided a non-transitory computer readable medium having instructions thereon, the instructions when executed by a computer implementing the method of any of the embodiments described above.

According to another embodiment, there is provided a non-transitory computer readable medium having instructions thereon, the instructions when executed by a computer causing the computer to: determine a sequence of states of a processed object, the states determined based on processing information associated with the object; determine, based on at least one of the states within the sequence of states, a process metric associated with the object, the process metric comprising an indication of whether processing requirements for the object are satisfied for individual states in the sequence of states; and initiate an adjustment to the processing process based on (1) at least one of the states within the sequence of states and (2) the process metric, the adjustment configured to enhance the process metric for the individual states in the sequence of states such that final processing requirements for the object are satisfied.

In an embodiment, the sequence of states corresponds to a sequence of processing operations performed for the object, and determining the sequence of states, determining the process metric, and initiating the adjustment comprises: determining a policy function, P(s), that defines processing operation corrections for individual states, equipment for performing the processing operations, and/or one or more process parameters for the processing operations; and/or determining a value function, V(s), that defines the enhancement of the process metric assuming the policy function is followed until completion of the sequence of processing operations.

In an embodiment, the value function defines an expected process metric for a given state (s).

In an embodiment, the computer is associated with a semiconductor processing environment, and the processed object is a semiconductor wafer, or one or more portions of the semiconductor wafer.

In an embodiment, the process metric comprises one or more of yield, cost of senor measurements, throughput, an indication of a tradeoff between yield optimization and measurement density, cost of overlay measurements, or overlay.

In an embodiment, the process metric comprises a reward, and the computer comprises an agent.

In an embodiment, the process metric comprises yield, and enhancing the process metric for the individual states in the sequence of states such that final processing requirements for the object are satisfied comprises increasing the yield.

In an embodiment, the process metric and/or the adjustment is determined based on at least two of the states within the sequence of states.

In an embodiment, the process metric and/or the adjustment is determined based on a plurality of the states within the sequence of states.

In an embodiment, initiating the adjustment comprises (1) optimizing the process metric based on the sequence of states, and determining the adjustment based on the optimized process metric; and/or (2) prompting a user to make the adjustment.

In an embodiment, the adjustment comprises a correction.

In an embodiment, the correction is an exposure correction associated with a semiconductor processing process.

In an embodiment, the adjustment comprises an indication of where, when, and/or how to measure the object during one or more processing operations.

In an embodiment, the sequence of states corresponds to a sequence of processing operations performed for the object, and the adjustment comprises one or more of a change in which processing operations are performed, a change in an order in which the processing operations are performed, or a change in one or more pieces of equipment used to perform one or more of the processing operations.

In an embodiment, the adjustment comprises a change in one or more process parameters of the one or more processing operations.

In an embodiment, the one or more process parameters comprise one or more of a dose, a focus, a mask design, an exposure level, one or more etch parameters, one or more deposition parameters, or one or more measurement parameters.

In an embodiment, the sequence of states corresponds to a sequence of processing operations performed for the object, and the processing information comprises one or more of values of measurements of the object performed as part of the processing operations, an indication of which processing operations were performed, an indication of an order of the sequence of processing operations, an indication of which equipment was used in the processing operations and/or associated machine constants, or processing parameters of the processing operations.

In an embodiment, determining the sequence of states, determining the process metric, and initiating the adjustment are performed as at least part of a model free reinforcement learning (MFRL) framework.

In an embodiment, the MFRL framework comprises one or more of an asynchronous advantage actor-critic algorithm, a Q-learning with normalized advantage function, a trust region policy optimization algorithm, a proximal policy optimization algorithm, a twin delayed deep deterministic policy gradient, or a soft actor-critic algorithm.

In an embodiment, the sequence of states includes one or more future states of the object, and determining the process metric is based on the sequence of states including the one or more future states; and initiating the adjustment to the processing process is based on the sequence of states, including the one or more futures states, and the process metric.

In an embodiment, the instructions further cause the computer to compare a first sequence of one or more processing operations having first process parameters to a second sequence of one or more processing operations having second process parameters based on policy functions and value functions associated with the first and second sequences.

In an embodiment, the instructions further cause the computer to perform the determining of the sequence of states, the determining of the process metric, and the initiating of the adjustment as part of a serving operational phase; and prior to the serving phase, training the policy function and/or the value function during a training operational phase.

In an embodiment, the training operational phase is performed in a simulated semiconductor processing environment.

According to another embodiment, there is provided a lithography apparatus. The apparatus comprises: an illumination source and projection optics configured to image a pattern onto a substrate; and one or more processors configured by machine readable instructions to: determine a sequence of states of a processed object, the states determined based on processing information associated with the object; determine, based on at least one of the states within the sequence of states, a process metric associated with the object, the process metric comprising an indication of whether processing requirements for the object are satisfied for individual states in the sequence of states; and initiate an adjustment to the processing process based on (1) at least one of the states within the sequence of states and (2) the process metric, the adjustment configured to enhance the process metric for the individual states in the sequence of states such that final processing requirements for the object are satisfied.

In an embodiment, the adjustment comprises a change in a process parameter associated with the illumination source, projection optics, the pattern, and/or the substrate.

In an embodiment, the processing process is a semiconductor processing process, and the processed object is a semiconductor wafer, or one or more portions of the semiconductor wafer.

In an embodiment, the process metric comprises yield, and satisfying the processing requirements comprises increasing the yield.

In an embodiment, initiating the adjustment comprises optimizing the process metric based on the sequence of states, and determining the adjustment based on the optimized process metric.

In an embodiment, the adjustment is an exposure correction associated with the lithography apparatus.

In an embodiment, determining the sequence of states, determining the process metric, and initiating the adjustment are performed as at least part of a model free reinforcement learning (MFRL) framework.

In an embodiment, the sequence of states includes one or more future states of the object, determining the process metric is based on the sequence of states including the one or more future states; and initiating the adjustment to the processing process is based on the sequence of states, including the one or more futures states, and the process metric.

In an embodiment, the sequence of states corresponds to a sequence of processing operations performed for the object, satisfying the processing requirements comprises enhancing the process metric, and initiating the adjustment comprises: determining a policy function, P(s), that defines processing operation corrections for individual states, equipment for performing the processing operations, and/or one or more process parameters for the processing operations; and/or determining a value function, V(s), that defines the enhancement of the process metric assuming the policy function is followed until completion of the sequence of processing operations.

According to another embodiment, there is provided a semiconductor processing method. The method comprises determining, with one or more physical processors, a sequence of states of a processed object. The states are determined based on processing information associated with the object. The method comprises determining, with the one or more processors, based on at least one of the states within the sequence of states, a process metric associated with the object. The process metric indicates a quality of processing for individual states in the sequence of states. The method comprises initiating, with the one or more processors, an adjustment to a processing process based on (1) at least one of the states within the sequence of states and (2) the process metric. The adjustment is configured to enhance the process metric for the individual states in the sequence of states such that final processing requirements meet a quality criterion.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Fig. 1 shows a block diagram of various subsystems of a lithography system, according to an embodiment.
Fig. 2 illustrates a schematic overview of a lithographic cell, according to an embodiment.
Fig. 3 illustrates a schematic representation of holistic lithography, representing a cooperation between three technologies to optimize semiconductor processing, according to an embodiment.
Fig. 4 illustrates a summary of operations of a present method for using reinforcement learning for yield aware process control.
Fig. 5 illustrates how a decision-making agent interacts with the other components of a reinforcement learning framework, according to an embodiment.
Fig. 6 illustrates possible states for different layers of a wafer, according to an embodiment.
Fig. 7 illustrates a training operational phase and a serving operational phase of the reinforcement learning framework, according to an embodiment.
Fig. 8 illustrates an implementation of a model free reinforcement learning framework for the use case of yield-aware overlay control, according to an embodiment.
Fig. 9 is a block diagram of an example computer system, according to an embodiment.
Fig. 10 is a schematic diagram of a lithographic projection apparatus, according to an embodiment.
Fig. 11 is a schematic diagram of another lithographic projection apparatus, according to an embodiment.
Fig. 12 is a more detailed view of the apparatus in Fig. 11, according to an embodiment.
Fig. 13 is a more detailed view of the source collector module SO of the apparatus of Fig. 11 and Fig. 12, according to an embodiment.

### DETAILED DESCRIPTION

Corrections and/or other adjustments to layers on a wafer are typically based on information from an immediately previous layer of the wafer. For example, a correction for a subsequent layer may be determined based on a single measurement such as overlay associated with the previous layer. Often, there is no through (wafer) stack process metric (e.g., yield) optimization. For example, there is no balancing of corrections in various layers of a stack for variation caused by particular processes and/or tools used during processing of different prior layers. There are no process adjustments based on whether an earlier processing process (e.g., for one or more layers before the immediately previous layer) caused a wafer, or a portion of a wafer, to not meet processing specifications.

Advantageously, the present system and method use a model free reinforcement learning approach to determine a relationship between sequences of states of a wafer and a process metric (e.g., a final yield) for the wafer, and make corrections that optimize the process metric (e.g., yield and/or processing costs). The present system and method include a training phase where a vast training data set comprising performance, context, scanner, and yield (or yield proxy), and/or other data are used for training. The system and method can then be used to determine, for a processed wafer associated with a certain state (e.g., a wafer having a specific processing history for example), an optimal policy (e.g., a sequence of through stack actions) that produces an optimum yield and/or a processing process having a lowest cost (e.g., in view of metrology time, materials, etc.), for example.

Although specific reference may be made in this text to overlay error correction via advanced process control (APC) systems, the framework described here may apply to other metrology processes, such as but not limited to, alignment processes, focusing processes, dose determination, smart sampling, etc.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. In these alternative applications, the skilled artisan will appreciate that, in the context of such alternative applications, any use of the terms "reticle", "wafer" or "die" in this text should be considered as interchangeable with the more general terms "mask", "substrate" and "target portion", respectively. In addition, it should be noted that the system(s) and method(s) described herein may have many other possible applications in diverse fields such as language processing systems, self-driving cars, medical imaging and diagnosis, semantic segmentation, denoising, chip design, electronic design automation, etc. The present system(s) and method(s) may be applied in any fields where model free reinforcement learning is advantageous.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

A patterning device may comprise, or may form, one or more design layouts. The design layout may be generated utilizing CAD (computer-aided design) programs. This process is often referred to as EDA (electronic design automation). Most CAD programs follow a set of predetermined design rules in order to create functional design layouts/patterning devices. These rules are set based processing and design limitations. For example, design rules define the space tolerance between devices (such as gates, capacitors, etc.) or interconnect lines, to ensure that the devices or lines do not interact with one another in an undesirable way. One or more of the design rule limitations may be referred to as a "critical dimension" (CD). A critical dimension of a device can be defined as the smallest width of a line or hole, or the smallest space between two lines or two holes. Thus, the CD regulates the overall size and density of the designed device. One of the goals in device fabrication is to faithfully reproduce the original design intent on the substrate (via the patterning device).

The term "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective; binary, phase-shifting, hybrid, etc.), examples of other such patterning devices include a programmable mirror array. An example of such a device is a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind; in this manner, the beam becomes patterned according to the addressing pattern of the matrix-addressable surface. The required matrix addressing can be performed using suitable electronic means. Examples of other such patterning devices also include a programmable LCD array. An example of such a construction is given in U.S. Patent No. 5,229,872, which is incorporated herein by reference.

The term "projection optics" as used herein should be broadly interpreted as encompassing various types of optical systems, including refractive optics, reflective optics, apertures and catadioptric optics, for example. The term "projection optics" may also include components operating according to any of these design types for directing, shaping or controlling the projection beam of radiation, collectively or singularly. The term "projection optics" may include any optical component in the lithographic projection apparatus, no matter where the optical component is located on an optical path of the lithographic projection apparatus. Projection optics may include optical components for shaping, adjusting and/or projecting radiation from the source before the radiation passes the patterning device, and/or optical components for shaping, adjusting and/or projecting the radiation after the radiation passes the patterning device. The projection optics generally exclude the source and the patterning device.

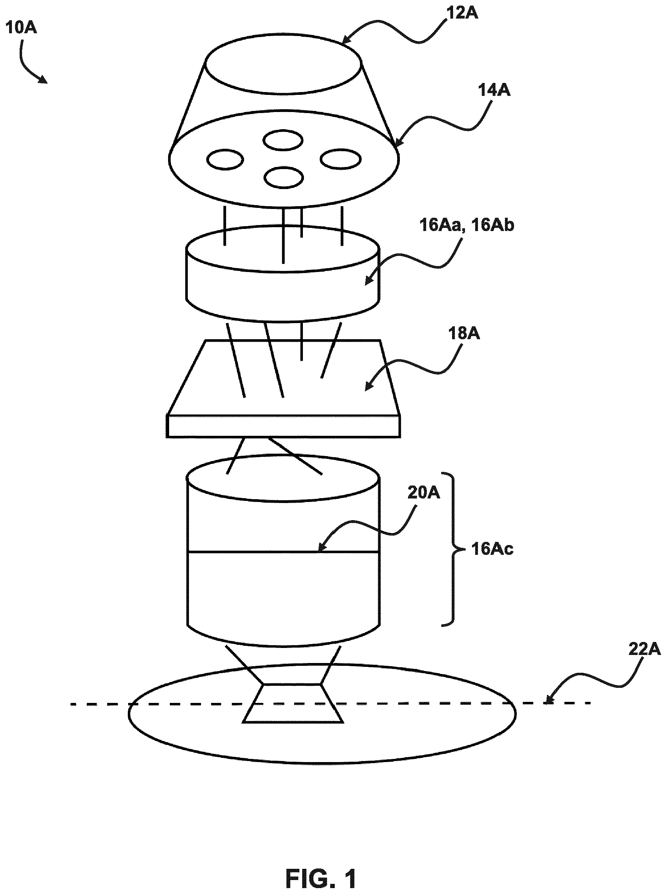

As a brief introduction, Fig. 1 illustrates an exemplary lithographic projection apparatus 10A. Major components are a radiation source 12A, which may be a deep-ultraviolet (DUV) excimer laser source or other type of source including an extreme ultra violet (EUV) source (as discussed above, the lithographic projection apparatus itself need not have the radiation source), illumination optics which, for example, define the partial coherence (denoted as sigma) and which may include optics 14A, 16Aa and 16Ab that shape radiation from the source 12A; a patterning device 18A; and transmission optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics NA= n sin(Θₘₐₓ), wherein n is the refractive index of the media between the substrate and the last element of the projection optics, and Θₘₐₓ is the largest angle of the beam exiting from the projection optics that can still impinge on the substrate plane 22A.

In a lithographic projection apparatus, a source provides illumination (i.e. radiation) to a patterning device and projection optics direct and shape the illumination, via the patterning device, onto a substrate. The projection optics may include at least some of the components 14A, 16Aa, 16Ab and 16Ac. An aerial image (AI) is the radiation intensity distribution at substrate level. A resist model can be used to calculate the resist image from the aerial image, an example of which can be found in U.S. Patent Application Publication No. US 2009-0157630, the disclosure of which is hereby incorporated by reference in its entirety. The resist model is related only to properties of the resist layer (e.g., effects of chemical processes that occur during exposure, post-exposure bake (PEB) and development). Optical properties of the lithographic projection apparatus (e.g., properties of the illumination, the patterning device and the projection optics) dictate the aerial image and can be defined in an optical model. Since the patterning device used in the lithographic projection apparatus can be changed, it is desirable to separate the optical properties of the patterning device from the optical properties of the rest of the lithographic projection apparatus including at least the source and the projection optics. Details of techniques and models used to transform a design layout into various lithographic images (e.g., an aerial image, a resist image, etc.), apply OPC using those techniques and models and evaluate performance (e.g., in terms of process window) are described in U.S. Patent Application Publication Nos. US 2008-0301620, 2007-0050749, 2007-0031745, 2008-0309897, 2010-0162197, and 2010-0180251, the disclosure of each being hereby incorporated by reference in its entirety.

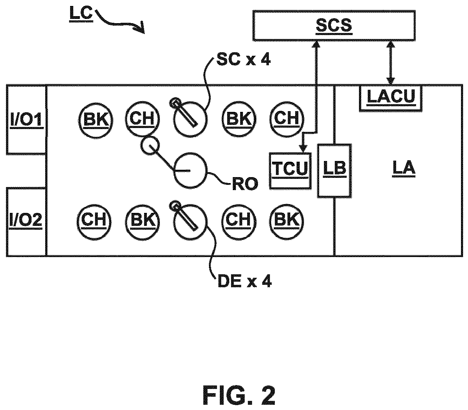

Fig. 2 depicts a schematic overview of a lithographic cell LC. As shown in Fig. 2 the lithographic apparatus LA may form part of lithographic cell LC, also sometimes referred to as a lithocell or (litho)cluster, which often also includes apparatus to perform pre- and post-exposure processes on a substrate W. Conventionally, these include spin coaters SC configured to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates, especially if the inspection is done before other substrates of the same batch or lot are still to be exposed or processed.

An inspection apparatus, which may also be referred to as a metrology apparatus, is used to determine properties of the substrates, and how properties of different substrates vary or how properties associated with different layers of the same substrate vary from layer to layer. The inspection apparatus may alternatively be constructed to identify defects on the substrate and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

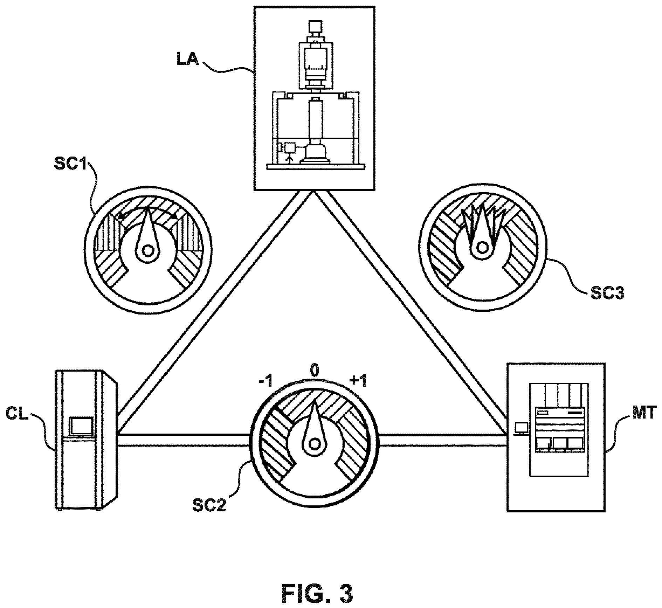

Fig. 3 depicts a schematic representation of holistic lithography, representing a cooperation between three technologies to optimize semiconductor processing. Typically, the patterning process in a lithographic apparatus LA is one of the most critical steps in the processing which requires high accuracy of dimensioning and placement of structures on the substrate. To ensure this high accuracy, three systems (in this example) may be combined in a so called "holistic" control environment as schematically depicted in Fig. 3. One of these systems is the lithographic apparatus LA which is (virtually) connected to a metrology apparatus (e.g., a metrology tool) MT (a second system), and to a computer system CL (a third system). A "holistic" environment may be configured to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific processing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology apparatus (tool) MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequent measurements of the structures created, e.g., for process control and verification. Tools to make such measurements include metrology tool (apparatus) MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure features of a substrate such as gratings using light from soft x-ray and visible to near-IR wavelength range, for example.

In some embodiments, scatterometer MT is adapted to measure the overlay of two misaligned gratings or periodic structures (and/or other target features of a substrate) by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in patent application EP1,628,164A, such that any asymmetry is clearly distinguishable. This provides a way to measure misalignment in gratings. Further examples for measuring overlay may be found in PCT patent application publication no. WO 2011/012624 or US patent application US 20160161863, incorporated herein by reference in their entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure (e.g., feature in a substrate) may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

It is often desirable to be able computationally determine how a patterning process would produce a desired pattern on a substrate. Computational determination may comprise simulation, for example. Simulations may be provided for one or more parts of the processing process. For example, it is desirable to be able to simulate the lithography process of transferring the patterning device pattern onto a resist layer of a substrate as well as the yielded pattern in that resist layer after development of the resist, simulate metrology operations such as the determination of overlay, and/or perform other simulations. The objective of a simulation may be to accurately predict, for example, metrology metrics (e.g., overlay, a critical dimension, a reconstruction of a three dimensional profile of features of a substrate, a dose or focus of a lithography apparatus at a moment when the features of the substrate were printed with the lithography apparatus, etc.), processing process parameters (e.g., edge placements, aerial image intensity slopes, sub resolution assist features (SRAF), etc.), and/or other information which can then be used to determine whether an intended or target design has been achieved. The intended design is generally defined as a pre-optical proximity correction design layout which can be provided in a standardized digital file format such as GDSII, OASIS or another file format.

Simulation can be used to determine one or more metrology metrics (e.g., overlay and/or other metrology measurements), configure one or more features of the patterning device pattern (e.g., by simulating optical proximity correction), configure one or more features of the illumination (e.g., by simulating the changing of one or more characteristics of a spatial / angular intensity distribution of the illumination, such as change a shape), configure one or more features of the projection optics (e.g., numerical aperture, etc.), and/or for other purposes. Such determination and/or configuration can be generally referred to as mask optimization, source optimization, and/or projection optimization, for example. Such optimizations can be performed on their own, or combined in different combinations. One such example is source-mask optimization (SMO), which involves the configuring of one or more features of the patterning device pattern together with one or more features of the illumination. The optimizations may use the parameterized model described herein to predict values of various parameters (including images, etc.), for example.

In some embodiments, an optimization process of a system may be represented as a cost function. The optimization process may comprise finding a set of parameters (design variables, process variables, etc.) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system or fabrication method. The design and/or process variables of the system can be confined to finite ranges and/or be interdependent due to practicalities of implementations of the system and/or method. In the case of a lithographic projection apparatus, the constraints are often associated with physical properties and characteristics of the hardware such as tunable ranges, and/or patterning device manufacturability design rules. The evaluation points can include physical points on a resist image on a substrate, as well as non-physical characteristics such as dose and focus, for example.

In some embodiments, the present system(s) and method(s) may include one or more processors configured to perform one or more of the operations described herein. The one or more processors may comprise one or more algorithms and/or other programming configured to simulate and/or otherwise predict outputs based on correlations between various inputs (e.g., one or more characteristics of an electric field image, one or more characteristics of a design layout, one or more characteristics of the patterning device, one or more characteristics of the illumination used in the lithographic process such as the wavelength, etc.).

As an example, an algorithm may be a machine learning algorithm. In some embodiments, the machine learning algorithm may be and/or include mathematical equations, other algorithms, plots, charts, networks (e.g., neural networks), and/or other tools and machine learning components. For example, the machine learning algorithm may be and/or include one or more neural networks having an input layer, an output layer, and one or more intermediate or hidden layers. In some embodiments, the one or more neural networks may be and/or include deep neural networks (e.g., neural networks that have one or more intermediate or hidden layers between the input and output layers).

As an example, the one or more neural networks may be based on a large collection of neural units (or artificial neurons). The one or more neural networks may loosely mimic the manner in which a biological brain works (e.g., via large clusters of biological neurons connected by axons). Each neural unit of a neural network may be connected with many other neural units of the neural network. Such connections can be enforcing or inhibitory in their effect on the activation state of connected neural units. In some embodiments, each individual neural unit may have a summation function that combines the values of all its inputs together. In some embodiments, each connection (or the neural unit itself) may have a threshold function such that a signal must surpass the threshold before it is allowed to propagate to other neural units. These neural network systems may be self-learning and trained, rather than explicitly programmed, and can perform significantly better in certain areas of problem solving, as compared to traditional computer programs. In some embodiments, the one or more neural networks may include multiple layers (e.g., where a signal path traverses from front layers to back layers). In some embodiments, back propagation techniques may be utilized by the neural networks, where forward stimulation is used to reset weights on the "front" neural units. In some embodiments, stimulation and inhibition for the one or more neural networks may be freer flowing, with connections interacting in a more chaotic and complex fashion. In some embodiments, the intermediate layers of the one or more neural networks include one or more convolutional layers, one or more recurrent layers, and/or other layers.

The one or more machine learning algorithms may be trained (i.e., whose parameters are determined) using a set of training data. The training data may include a set of training samples. Each sample may be a pair comprising an input object (typically an image, a measurement, a tensor or vector which may be called a feature tensor or vector) and a desired output value (also called the supervisory signal). A training algorithm analyzes the training data and adjusts the behavior of the algorithm by adjusting the parameters of the algorithm based on the training data. For example, given a set of N training samples of the form {(x₁, y₁), (x₂, y₂), ..., (x_{N}, y_{N})} such that x; is the feature tensor / vector of the i-th example and yᵢ is its supervisory signal, a training algorithm seeks a result g: X → Y, where X is the input space and Y is the output space. A feature tensor / vector is an n-dimensional tensor / vector of numerical features that represent some object (e.g., a complex electric field image). The tensor / vector space associated with these vectors is often called the feature or latent space. After training, the algorithm may be used for making predictions using new samples.

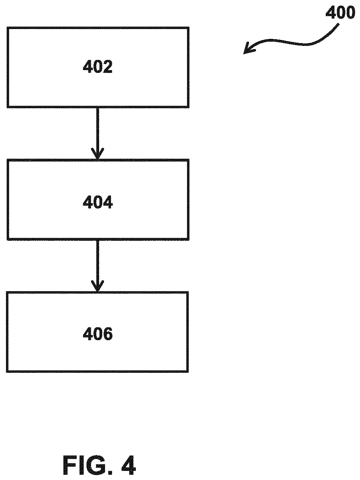

Fig. 4 illustrates a summary of operations of a present method 400 for using reinforcement learning for process metric (e.g., yield) aware process control. In a semiconductor processing process, certain parameters, such as overlay (e.g., layer-to-layer alignment offset), Critical Dimension (CD), etc., are measured to ensure the process is proceeding according to (satisfying) processing requirements. These measurements are used to monitor and control the processing process. These measurements, along with additional context data (e.g., which machines and/or other equipment was used, which process parameters were used, etc.), for an immediately previous layer are used in a subsequent layer to initiate adjustments to the semiconductor processing process (e.g., using Advanced Process Control (APC) systems) for that subsequent layer.

In a given wafer some layers are more critical than others. Some layers have tighter processing requirements that other layers. For example, implant layers are less critical than via layers, which need to be tightly aligned with respect to a metal layer. These critical layers typically require more dense quality inspection measurements. As another example, layers that include optimally designed metrology targets are important to identifying process variation and eventually producing a working device. However, even given the criticality of these and other layers in a wafer, typical adjustments to layers on the wafer are based only on information from an immediately previous layer of the wafer and do not consider information from additional previous layers (e.g., indicating dimensions of those previous layers, alignment of those previous layers, overlay of those previous layers, whether a wafer or a portion of the wafer has already failed processing requirements, and/or other information).

Among other disadvantages, prior systems lack through stack yield (and/or other similar process metric) awareness. Yield is the measure of a functioning integrated circuit (semiconductor device). Often, prior systems simply attempt to minimize overlay between two adjacent layers (or meet some other processing requirement). Prior systems do not consider potential through stack effects on overlay (and/or other parameters) that affect yield. Continuing with this example, it may be that the process used for the first several layers of a semiconductor device produced several areas of a wafer with zero yield, which will consequently be scrapped. Theoretically, in a next subsequent layer of the wafer, adjustments should be applied such that the zero yield areas of the wafer are not a priority or are even ignored. However, prior systems are not configured in this way.

As another example, prior systems require dense, time-consuming measurements. Dense measurements are often performed for critical layers and less dense measurements for noncritical layers. The measurements are not adjusted based on yield and/or other factors. Measurement density is not adjusted based on information from prior layers in a stack. As another example, different lithographic scanners and other different process machines and/or equipment including different metrology tools, may incur different fingerprints on a wafer. Certain combinations of machines and/or other process equipment might produce a very poor yield performance despite applied corrections. Other combinations of machines and/or other process equipment may produce high yield. However, prior systems typically do not adjust for these combinations of prior machines and/or other equipment based on yield, for example.

In contrast to prior systems, the present system and method are configured to use reinforcement learning for yield aware (and/or other process metric) process control. Data driven through stack adjustments are made. Adjustments are based on relevant historical data for wafer measurements and/or other information from more than just the immediately previous layer, the machines and/or process equipment used for fabricating and/or measuring those layers, and/or other information. In addition, the present system is configured to consider the impact adjustments have on overall yield (and/or other process metrics), for example, for a semiconductor device. For example, with the present system and method, exposure corrections (as one example of many possible adjustments) are not applied simply to minimize overlay error, CD errors, etc., in a particular layer. Instead, exposure corrections (for example) are applied with the goal of optimizing yield (and/or other process metrics) by adapting an entire sequence of corrections and scanner combinations (and/or other adjustments) through a stack. The present system and method are also configured to reduce measurement cost, by determining a sequence of corrections (adjustments) that require less dense measurements, without having to sacrifice yield. In addition, the present system and method are configured to compare expected scanner-process machine and/or other equipment combinations, and facilitate identification of an optimum set of processing operations, including the machines and/or other equipment used for the operations, for a wafer. The present system and method utilize model free reinforcement learning (MFRL), as described herein, to achieve these and other advantages.

In some embodiments, as described herein, method 400 is performed in a semiconductor processing environment (e.g., the "environment" for MFRL as described below). At an operation 402, a sequence of states of a processed object (e.g., a semiconductor wafer and/or other objects) is determined. At an operation 404, a process metric associated with the object (e.g., yield and/or other process metrics and/or quality criteria) is determined. At an operation 406, an adjustment to a processing process is initiated based on (1) at least one of the states within the sequence of states and (2) the process metric. The adjustment is configured to enhance the process metric for the individual states in the sequence of states such that final processing requirements for the object are satisfied (e.g., such that the processing process yields a working semiconductor device). The process metric may indicate a quality of processing for individual states in the sequence of states, for example. The adjustment may enhance the process metric for individual states in the sequence of states such that final processing requirement meet a quality criterion (e.g., a specific yield percentage, etc.).

The operations of method 400 presented below are intended to be illustrative. In some embodiments, method 400 may be accomplished with one or more additional operations not described, and/or without one or more of the operations discussed. For example, method 400 may include a training operation as described below. Additionally, the order in which the operations of method 400 are illustrated in Fig. 4 and described below is not intended to be limiting.

In some embodiments, one or more portions of method 400 may be implemented (e.g., by simulation, etc.) in one or more processing devices (e.g., one or more processors). The one or more processing devices may include one or more devices executing some or all of the operations of method 400 in response to instructions stored electronically on an electronic storage medium. The one or more processing devices may include one or more devices configured through hardware, firmware, and/or software to be specifically designed for execution of one or more of the operations of method 400, for example. In some embodiments, one or more processors form an "agent" of a MFRL framework, for example (as further described below).

Operation 402 comprises determining a sequence of states of a processed object. In some embodiments, the processed object is a semiconductor wafer, or one or more portions of the semiconductor wafer, and/or other objects. For example, the one or more portions of the semiconductor wafer may be one or more portions that meet processing requirements up to a current point in a processing process. This may include individual chips, for example, and/or other portions of a wafer.

In some embodiments, the sequence of states corresponds to a sequence of processing operations performed for the object. For example, a given state may correspond to a wafer immediately before or after a specific lithography operation, an etching operation, a deposition operation, and/or other operations in a processing process. In some embodiments, the sequence of states includes one or more future states of the object. For example, the future state may include a wafer that has undergone one or more additional lithography operations, etching operations, deposition operations, and/or other operations up to and including finishing operations for completing the manufacture of a semiconductor device.

The states are determined based on processing information associated with the object and/or other information. In some embodiments the processing information comprises values of measurements of the object performed as part of the processing operations, an indication of which processing operations were performed, an indication of an order or of the sequence of processing operations, an indication of which machines and/or other equipment was used in the processing operations, constants for such machines and/or other equipment, processing parameters of the processing operations, and or other processing information. For example, the processing information may include an indication of which metrology apparatus was used to measure overlay, and the overlay value itself.

Operation 404 comprises determining, based on at least one of the states within the sequence of states, a process metric associated with the object. In some embodiments the process metric is determined based on two or more of the states within sequence states, a plurality of states within sequence of states, or all of the states within sequence states. In some embodiments, the process metric is determined based on the sequence of states including the one or more future states.

The process metric comprises an indication of whether processing requirements for the object are satisfied for individual states in the sequence of states. The process metric may indicate a quality of processing for individual states in the sequence of states. The process metric may be, and/or be related to a specific quality criterion such as a specific yield percentage, and/or other criteria, for example. In some embodiments, the process metric comprises yield, cost of sensor measurements, throughput, an indication of a trade-off between yield optimization and measurement density, cost of overlay measurements, overlay, and/or other process metrics. In some embodiments, the process metric comprises yield. In these embodiments, enhancing the process metric for the individual states in the sequence of states such that final processing requirements for the object are satisfied (e.g., and/or such that final processing requirements meet a quality criterion) comprises increasing the yield. The process metric and/or enhancement of the process metric may be the "reward" in MFRL, for example (as described below).

Operation 406 comprises initiating an adjustment to the processing process. The adjustment is initiated based on at least one of the states within the sequence of states, the process metric, and/or other information. In some embodiments, initiating the adjustment to the processing process is based on the sequence of states, including the one or more future states, and the process metric. The adjustment is configured to enhance the process metric for the individual states in the sequence of states such that final processing requirements for the object are satisfied (e.g., and/or such that final processing requirements meet a quality criterion). In some embodiments, initiating the adjustment comprises optimizing the process metric based on the sequence of states, and determining the adjustment based on the optimized process metric. The adjustment may be a change in a processing process parameter, a correction to an aspect of the processing process, a change in the processing operations themselves, and/or other adjustments.

In some embodiments a change in a processing process parameter may be an increase or a decrease in the process parameter, a different value for the process parameter, and/or some other change in a process parameter. In some embodiments, the one or more process parameters comprise a dose, focus, a master design, an exposure level, one or more etching parameters, one or more parameters associated with adjustments to an edge of a device structure (as in Edge Placement Control), one or more deposition parameters, one or more measurement parameters, and/or other parameters. For example, in some embodiments, the adjustment may comprise a change in a process parameter associated with an illumination source, projection optics, a pattern, the substrate, and/or other aspects of a semiconductor and/or a semiconductor processing process.

In some embodiments the adjustment comprises a correction. In some embodiments the correction is an exposure correction associated with the semiconductor processing process, and/or other corrections. For example, other corrections may include corrections to the mask or to the patterns on the mask, corrections to the alignment recipe, corrections to the overlay metrology recipe, corrections to the Automatic Process Control (APC) recipe, APC corrections imparted to equipment by, for example, adjusting mask alignment, projection optics settings, illumination source settings, stage positioning settings, corrections to the fab tool routing and matching recipes, corrections to the equipment maintenance recipes, and/or other corrections.

In some embodiments, the adjustment comprises an indication of where, when, and/or how to measure the object during one or more processing operations. In some embodiments, the adjustment comprises a change in which processing operations are performed on the object, a change in an order in which the processing operations are performed, a change in one or more machines and/or other pieces of equipment used to perform one or more of the processing operations, and/or other adjustments.

In some embodiments initiating the adjustment comprises prompting a user to make the adjustment. Prompting a user to make the adjustment may include providing a message and or other indication of the adjustment to the user. The message and/or other indication may be provided on a user interface of a computing device associated with the user, a user interface of a computing device associated with a processing operation, and/or other interfaces. In some embodiments, prompting the user to make the adjustment comprises facilitating entry and/or selection of the adjustment by the user through a user interface, and/or other prompting.

As described above, determining the sequence of states (operation 402), determining the process metric (operation 404), and initiating the adjustment (operation 406) are performed as at least part of a model free reinforcement learning (MFRL) framework. The MFRL framework comprises a machine learning algorithm configured for sequential decision-making. The decisions (e.g., actions and/or other adjustments) taken in a given situation (or state) are optimized to maximize a reward (e.g., enhancement of the yield and/or other process metrics). The basic components of the MFRL framework include a set of states (e.g., as described above), a set of actions (e.g., adjustments as described above), an agent (e.g., one or more processors as described above), an environment (e.g., a semiconductor processing process as described above), and a reward (e.g., the enhancement of the yield and/or other process metrics as described above).

A given state may include relevant historical data (processing information) for a particular wafer, and/or other information. Historical data (processing information) may include, measured overlay in previous layers, context data (e.g., scanners, reticles, process machines and/or other equipment, etc.) used on previous layers as well as on a current layer, and/or other information (including any additional processing information described above). The actions (adjustments) include corrections and/or other adjustments that may be implemented on processing machines and/or in processing processes, in associated electronic models, in product design, in metrology target layouts, etc. Note that this may be machine dependent. The agent is the decision-making framework that determines adjustments and actuates them in the processing process. The reward, in the yield-aware process adjustment case, is the enhanced yield accrued at the end of the processing process.

Optionally, a negative reward may be accrued for a given state in which an expensive (e.g., in time, yield, or other process metrics) set of adjustments is applied (higher order electronic models require more measurements, for example, so a cost for implementing such expensive corrections can be charged). This requires a trade-off between optimizing yield (and/or other process metrics) and minimizing dense measurements, for example.

The environment (e.g., the semiconductor processing process) is made up of all possible states, as well as all transitions between states. That is, whenever an action (e.g., an adjustment) is taken for a certain state, the wafer moves to a new state, and a reward (and/or cost) is accrued. The environment (individual states and transitions between states) may be learned from training data using machine learning (e.g., as described herein), and/or by other methods.

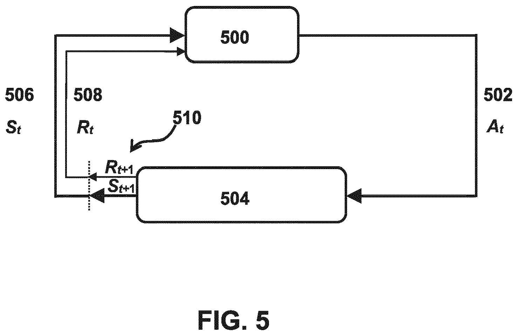

Fig. 5 illustrates how a decision-making agent interacts with the other components of a reinforcement learning framework. As shown in Fig. 5, an agent 500 (e.g., one or more processors) determines a given action (e.g., adjustment) 502 for a given environment (e.g., a semiconductor processing process) 504 based on a current state 506 and a corresponding reward 508. This process may be iteratively repeated 510 as necessary. In some embodiments, this arrangement comprises a Markov Decision Process. Because transitions from state to state are not known (e.g., predetermined) in a semiconductor processing context (e.g., a wafer can be processed using any one of a multitude of different possible processing operations), the decision making process by agent 500 comprises model-free reinforcement learning.

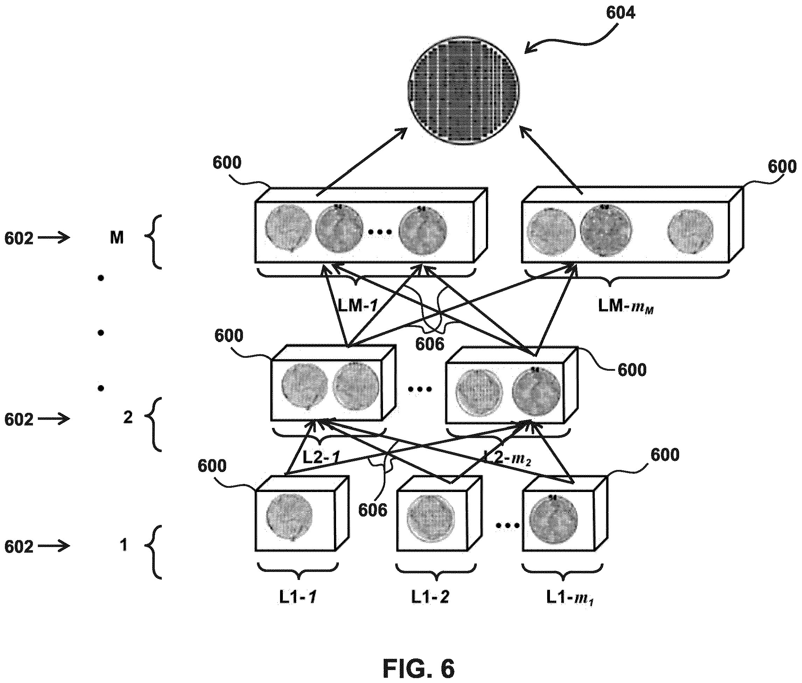

By way of a non-limiting example, Fig. 6 illustrates possible states 600 (L1-1, L1-2, ...LM-mₙ) for different layers 602 (1, 2, ..., M) of a wafer 604. The arrows 606 represent possible transitions between states that depend on the actions (e.g., adjustments) taken (made) by the agent (e.g., agent 500 shown in Fig. 5 - which is the one or more processors as described above). A yield (e.g., reward) is determined for the final wafer 604, and/or for each state. It should be noted that yield is used as one possible example of many process metrics. A state could, for example, represent the overlay error between the current and previous layer(s) of the wafer, depending on the wafer correction model. Other actions (e.g., causing transitions between states) may include making different types of scanner or process tool adjustments, for example.

The algorithms that solve model-free reinforcement learning problems are trial-and-error algorithms and/or other algorithms. In some embodiments, the MFRL framework comprises an asynchronous advantage actor critic algorithm, a Q - learning with normalized advantage function, a trust region policy optimization algorithm, a proximal policy optimization algorithm, a twin delayed deep deterministic policy gradient, a soft actor - critic algorithm, and/or other algorithms. In some embodiments the process metric, as described above, comprises a reward, and the one or more processors comprise an agent, with the environment being the semiconductor processing process.

Returning to Fig. 4, in some embodiments, determining the sequence of states (operation 402), determining the process metric (operation 404), and initiating the adjustment (operation 406) comprises determining a policy function, P(s), that defines processing operation corrections for individual states, machines and/or other equipment for performing the processing operations, one or more process parameters for the processing operations, and/or other information. Performing these operations also includes determining a value function, V(s), that defines the enhancement of the process metric assuming the policy function is followed until completion of the sequence of processing operations. In some embodiments, the value function defines an expected process metric for a given state (s).

The present system and method are configured to optimize a process metric such as yield. As such, adjustments (e.g., corrections, process parameter changes, process operation order adjustment, etc.) that are made for individual layers are determined based on the impact they will have on the process metric (e.g., yield) at the end of the semiconductor processing process. In other words, the present system and method are not only configured to determine and/or make adjustments for individual layers, but these adjustments follow a policy (e.g., a sequence of adjustments and/or other actions) for a full wafer.

The present system and method are configured such that individual adjustments incur a reward (e.g., an enhancement of a process metric such as yield), or a cost (e.g., negative reward such as reduced yield, increased processing time, increased measurement density, etc.). This facilitates consideration of costs for "expensive" adjustments (e.g., requiring more dense measurements, an additional process, etc.). This introduces a trade-off between maximizing a process metric such as yield and minimizing (e.g., measurement) cost. The output policy (sequence of adjustments) is configured to obtain an enhanced process metric (e.g., the highest possible yield) without breaching (e.g., exceeding) a target (e.g., measurement) budget (e.g., reduce measurement cost without compromising yield).

As a brief review, the present system and method are configured to use a MFRL framework to determine a function of type V(s), as well as a policy function P(s). P(s) defines the adjustments made for individual states s. V(s) indicates an (e.g., average) reward (e.g., process metric enhancement) that can be obtained if the starting point is state s, and policy P(s) is followed until the semiconductor processing process finishes. P(s) may represent adjustments including corrections, changes to process parameters, machines and/or other equipment that should be used to manufacture the wafer, operations and/or on order of operations used to manufacture the wafer, and/or other adjustments as discussed above. V(s) then defines individual (e.g., the "best") corrections to be applied in individual layers.

In some embodiments, operation 406 (Fig. 4) includes comparing a first sequence of one or more processing operations (e.g., a first policy) having first operations, process parameters, machines and/or other equipment, etc., to a second sequence of one or more processing operations (e.g., a second policy) having second operations, process parameters, machines and/or other equipment, etc.. The comparison is based on policy functions and value functions associated with the first and second sequences. Operation 406 includes selecting the first sequence or the second sequence, for example, based on which sequence produces an optimized process metric. As described above, the process metric may be yield, such that operation 406 includes selecting the first sequence or the second sequence based on which sequence produces a better yield.

In some embodiments determining the sequence of states, determining the process metric, and initiating the adjustment are performed as part of a serving operational phase. The serving phase may include using a policy function and a value function in actual processing and/or other use, for example. Prior to the serving phase, the policy function and the value function may be generated and/or a machine learning algorithm that generates the value function and/or the policy function may be trained during a training operational phase. In the training phase, the system performs explorative actions and thereby learns the policy function and the value function using occasional rewards and observations ("exploration"). In some embodiments, the training operational phase is performed in a simulated semiconductor processing environment and/or with simulated semiconductor processing data. In some embodiments, the training operational phase is performed with actual measurement data. In some embodiments, the training operational phase is performed with both the simulated and actual measurement data, and/or other information. In the serving phase, the learned policy and value function are used to generate new actions, for example.

For example, prior to serving an initial policy function and/or value function for use as described above, an algorithm may be generated and/or trained using training data. The training data comprises process and corresponding performance data, and may be associated with one or more different processing processes. The process data and corresponding performance data may comprise data for lithography and/or processing processes and/or process simulations, for example, associated with, related to, and/or representative of, the several processing operations described herein (e.g., see Fig. 1 - Fig. 3), and/or other data. Training the initial algorithm may comprise providing the training data to the initial algorithm as input to the initial algorithm (e.g., as described above). The initial prediction algorithm may operate to learn to better predict the performance data based on the corresponding process data. Learning to better predict performance may comprise iteratively updating one or more of the algorithm parameters (e.g., before or after serving), and determining whether the update resulted in a better or a worse prediction of the known performance data, for example.

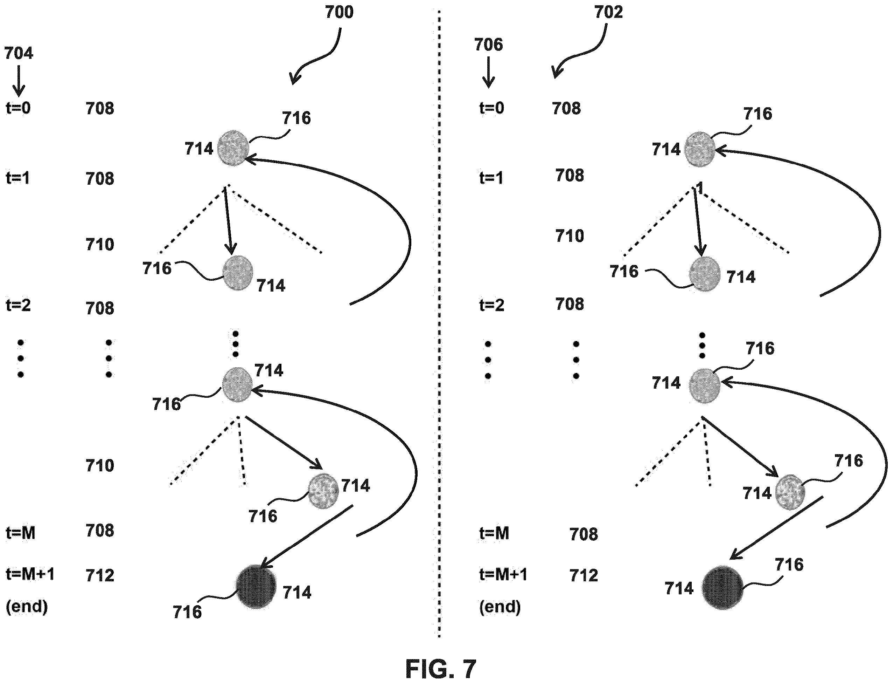

By way of a non-limiting example, Fig. 7 illustrates a training phase 700 and a serving phase 702. Both phases 700 and 702 show time sequences 704 and 706 with corresponding observations 708 (e.g., measurements on a given layer), actions 710 (e.g., one or more various corrections and/or other adjustments for individual layers indicated by arrows), rewards 712 (e.g., wafer yield enhancement), and different states 714 of a wafer 716. Fig. 7 illustrates an example of a sequence of adjustments (e.g., actions such as corrections) that might be taken by an agent in the MFRL framework for the use case of yield-aware overlay control. During training phase 700 the agent (e.g., 500 shown in Fig. 5) learns the policy and/or value function. During serving phase 702, the agent performs the optimal policy. The arrows represent the actions taken during a semiconductor wafer processing process. The dashed lines represent other possible actions that are not taken. The arrow of (M-1)-th action indicates an exploratory action, which may be taken even though another action was considered better. The curved arrows represent updates in the policy and/or value function.

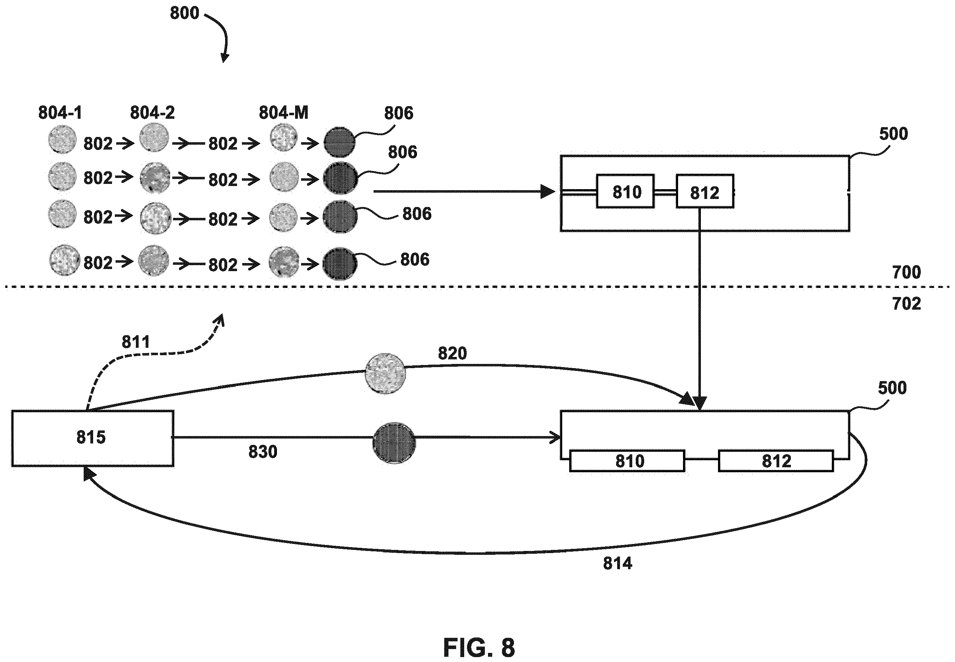

As a second non-limiting example, Fig. 8 illustrates an implementation of the MFRL framework for the use case of yield-aware overlay control. During training phase 700, training data 800 (e.g., as described above) is used to train agent 500 (e.g., one or more processors). Training data 800 comprises processing information indicating various adjustments 802 made to individual layers 804 (e.g., 804-1, 804-2, ...804-M), and a corresponding process metric (e.g., yield) enhancement for a wafer 806. During the training phase, agent 500 learns the policy 810 and/or the value 812 functions. In some embodiments, agent 500 may make some exploratory adjustments in order to find improved policies for system dynamics and/or for other reasons.

During serving phase 702, agent 500 performs 814 the optimal policy (e.g., 810 and/or 812) for a semiconductor processing process 815 and updates 811 training data 800 (e.g., to improve the policy) based on the information (e.g., processing information such as overlay measurements 820 and corresponding yield enhancements 830) generated during serving phase 702.

It should be noted that the systems and methods described herein may also be used for other applications such as smart sampling, alignment mark position optimization, and/or other applications. For smart sampling, the states may comprise all historical data for a particular wafer (e.g., processing information including overlay, focus, etc., measurements for previous layers, context information, as well as scanner sensor information, and/or other information. The actions (e.g., adjustments) may be Boolean, either yes or no. The agent may be a smart optimal sampling system such as SSO. The reward (process metric) for smart sampling may be turned into a cost. For example, every time the system decides to sample, a cost may be incurred, and at the end a positive reward may be accrued based on yield (and/or other process metrics). This may produce a sampling scheme that optimizes yield (and/or other process metrics), but finds a trade-off between measurement cost and end yield.

For alignment mark position optimization, the states may comprise historical data (e.g., processing information including overlay measurements of previous layers, all context information as well as scanner sensor information, and/or other processing information). The actions (e.g., adjustments) may define the layout of alignment marks on the wafer, for example. The agent is again one or more processors. The reward (process metric) in this example be an overlay key performance indicator that is accrued after the measurement of a layer.

Further embodiments of the invention are disclosed in the list of numbered clauses below:
1. A semiconductor processing method, the method comprising:
   determining, with one or more physical processors, a sequence of states of a processed object, the states determined based on processing information associated with the object;
   determining, with the one or more processors, based on at least one of the states within the sequence of states, a process metric associated with the object, the process metric comprising an indication of whether processing requirements for the object are satisfied for individual states in the sequence of states; and
   initiating, with the one or more processors, an adjustment to a processing process based on (1) at least one of the states within the sequence of states and (2) the process metric, the adjustment configured to enhance the process metric for the individual states in the sequence of states such that final processing requirements for the object are satisfied.
2. The method of clause 1, wherein the sequence of states corresponds to a sequence of processing operations performed for the object, and wherein determining the sequence of states, determining the process metric, and initiating the adjustment comprises:
   determining a policy function, P(s), that defines processing operation corrections for individual states, equipment for performing the processing operations, and/or one or more process parameters for the processing operations; and/or
   determining a value function, V(s), that defines the enhancement of the process metric assuming the policy function is followed until completion of the sequence of processing operations.
3. The method of clause 2, wherein the value function defines an expected process metric for a given state (s).
4. The method of any of clauses 1-3, wherein the method is performed for a semiconductor processing environment, and the processed object is a semiconductor wafer, or one or more portions of the semiconductor wafer.
5. The method of any of clauses 1-4, wherein the process metric comprises one or more of yield, cost of senor measurements, throughput, an indication of a tradeoff between yield optimization and measurement density, cost of overlay measurements, or overlay.
6. The method of any of clauses 1-5, wherein the process metric comprises a reward, and the one or more processors comprise an agent.
7. The method of any of clauses 1-6, wherein the process metric comprises yield, and enhancing the process metric for the individual states in the sequence of states such that final processing requirements for the object are satisfied comprises increasing the yield.
8. The method of any of clauses 1-7, wherein the process metric and/or the adjustment is determined based on at least two of the states within the sequence of states.
9. The method of any of clauses 1-8, wherein the process metric and/or the adjustment is determined based on a plurality of the states within the sequence of states.
10. The method of any of clauses 1-9, wherein initiating the adjustment comprises (1) optimizing the process metric based on the sequence of states, and determining the adjustment based on the optimized process metric; and/or (2) prompting a user to make the adjustment.
11. The method of any of clauses 1-10, wherein the adjustment comprises a correction.
12. The method of clause 11, wherein the correction is an exposure correction associated with the semiconductor processing process.
13. The method of any of clauses 1-12, wherein the adjustment comprises an indication of where, when, and/or how to measure the object during one or more processing operations.
14. The method of any of clauses 1-13, wherein the sequence of states corresponds to a sequence of processing operations performed for the object, and the adjustment comprises one or more of a change in which processing operations are performed, a change in an order in which the processing operations are performed, or a change in one or more pieces of equipment used to perform one or more of the processing operations.
15. The method of clause 14, wherein the adjustment comprises a change in one or more process parameters of the one or more processing operations.
16. The method of clause 15, wherein the one or more process parameters comprise one or more of a dose, a focus, a mask design, an exposure level, one or more etch parameters, one or more deposition parameters, or one or more measurement parameters.
17. The method of any of clauses 1-16, wherein the sequence of states corresponds to a sequence of processing operations performed for the object, and wherein the processing information comprises one or more of values of measurements of the object performed as part of the processing operations, an indication of which processing operations were performed, an indication of an order of the sequence of processing operations, an indication of which equipment was used in the processing operations and/or associated machine constants, or processing parameters of the processing operations.
18. The method of any of clauses 1-17, wherein determining the sequence of states, determining the process metric, and initiating the adjustment are performed as at least part of a model free reinforcement learning (MFRL) framework.
19. The method of clause 18, wherein the MFRL framework comprises one or more of an asynchronous advantage actor-critic algorithm, a Q-learning with normalized advantage function, a trust region policy optimization algorithm, a proximal policy optimization algorithm, a twin delayed deep deterministic policy gradient, or a soft actor-critic algorithm.
20. The method of any of clauses 1-19, wherein the sequence of states includes one or more future states of the object, wherein
   determining the process metric is based on the sequence of states including the one or more future states; and
   initiating the adjustment to the processing process is based on the sequence of states, including the one or more futures states, and the process metric.
21. The method of any of clauses 2-20, further comprising comparing, with the one or more processors, a first sequence of one or more processing operations having first process parameters to a second sequence of one or more processing operations having second process parameters based on policy functions and value functions associated with the first and second sequences.
22. The method of any of clauses 2-21, further comprising performing the determining of the sequence of states, the determining of the process metric, and the initiating of the adjustment as part of a serving operational phase; and/or
   prior to the serving phase, training the policy function and the value function during a training operational phase.
23. The method of clause 22, wherein the training operational phase is performed in a simulated semiconductor processing environment.
24. A non-transitory computer readable medium having instructions thereon, the instructions when executed by a computer implementing the method of any of clauses 1-23.
25. A non-transitory computer readable medium having instructions thereon, the instructions when executed by a computer causing the computer to:
   determine a sequence of states of a processed object, the states determined based on processing information associated with the object;
   determine, based on at least one of the states within the sequence of states, a process metric associated with the object, the process metric comprising an indication of whether processing requirements for the object are satisfied for individual states in the sequence of states; and
   initiate an adjustment to the processing process based on (1) at least one of the states within the sequence of states and (2) the process metric, the adjustment configured to enhance the process metric for the individual states in the sequence of states such that final processing requirements for the object are satisfied.
26. The medium of clause 25, wherein the sequence of states corresponds to a sequence of processing operations performed for the object, and wherein determining the sequence of states, determining the process metric, and initiating the adjustment comprises:
   determining a policy function, P(s), that defines processing operation corrections for individual states, equipment for performing the processing operations, and/or one or more process parameters for the processing operations; and/or
   determining a value function, V(s), that defines the enhancement of the process metric assuming the policy function is followed until completion of the sequence of processing operations.
27. The medium of clause 26, wherein the value function defines an expected process metric for a given state (s).
28. The medium of any of clauses 25-27, wherein the computer is associated with a semiconductor processing environment, and the processed object is a semiconductor wafer, or one or more portions of the semiconductor wafer.
29. The medium of any of clauses 25-28, wherein the process metric comprises one or more of yield, cost of senor measurements, throughput, an indication of a tradeoff between yield optimization and measurement density, cost of overlay measurements, or overlay.
30. The medium of any of clauses 25-29, wherein the process metric comprises a reward, and the computer comprises an agent.
31. The medium of any of clauses 25-30, wherein the process metric comprises yield, and enhancing the process metric for the individual states in the sequence of states such that final processing requirements for the object are satisfied comprises increasing the yield.
32. The medium of any of clauses 25-31, wherein the process metric and/or the adjustment is determined based on at least two of the states within the sequence of states.
33. The medium of any of clauses 25-32, wherein the process metric and/or the adjustment is determined based on a plurality of the states within the sequence of states.
34. The medium of any of clauses 25-33, wherein initiating the adjustment comprises (1) optimizing the process metric based on the sequence of states, and determining the adjustment based on the optimized process metric; and/or (2) prompting a user to make the adjustment.
35. The medium of any of clauses 25-34, wherein the adjustment comprises a correction.
36. The medium of clause 35, wherein the correction is an exposure correction associated with a semiconductor processing process.
37. The medium of any of clauses 25-36, wherein the adjustment comprises an indication of where, when, and/or how to measure the object during one or more processing operations.
38. The medium of any of clauses 25-37, wherein the sequence of states corresponds to a sequence of processing operations performed for the object, and the adjustment comprises one or more of a change in which processing operations are performed, a change in an order in which the processing operations are performed, or a change in one or more pieces of equipment used to perform one or more of the processing operations.
39. The medium of clause 38, wherein the adjustment comprises a change in one or more process parameters of the one or more processing operations.
40. The medium of clause 39, wherein the one or more process parameters comprise one or more of a dose, a focus, a mask design, an exposure level, one or more etch parameters, one or more deposition parameters, or one or more measurement parameters.
41. The medium of any of clauses 25-40, wherein the sequence of states corresponds to a sequence of processing operations performed for the object, and wherein the processing information comprises one or more of values of measurements of the object performed as part of the processing operations, an indication of which processing operations were performed, an indication of an order of the sequence of processing operations, an indication of which equipment was used in the processing operations and/or associated machine constants, or processing parameters of the processing operations.
42. The medium of any of clauses 25-41, wherein determining the sequence of states, determining the process metric, and initiating the adjustment are performed as at least part of a model free reinforcement learning (MFRL) framework.
43. The medium of clause 42, wherein the MFRL framework comprises one or more of an asynchronous advantage actor-critic algorithm, a Q-learning with normalized advantage function, a trust region policy optimization algorithm, a proximal policy optimization algorithm, a twin delayed deep deterministic policy gradient, or a soft actor-critic algorithm.
44. The medium of any of clauses 25-43, wherein the sequence of states includes one or more future states of the object, wherein
   determining the process metric is based on the sequence of states including the one or more future states; and
   initiating the adjustment to the processing process is based on the sequence of states, including the one or more futures states, and the process metric.
45. The medium of any of clauses 26-44, further comprising causing the computer to compare, a first sequence of one or more processing operations having first process parameters to a second sequence of one or more processing operations having second process parameters based on policy functions and value functions associated with the first and second sequences.
46. The medium of any of clauses 26-45, further comprising causing the computer to perform the determining of the sequence of states, the determining of the process metric, and the initiating of the adjustment as part of a serving operational phase; and/or
   prior to the serving phase, training the policy function and the value function during a training operational phase.
47. The medium of clause 46, wherein the training operational phase is performed in a simulated semiconductor processing environment.
48. A lithography apparatus, the apparatus comprising:
   an illumination source and projection optics configured to image a pattern onto a substrate; and
   one or more physical processors configured by machine readable instructions to:
      determine a sequence of states of a processed object, the states determined based on processing information associated with the object;
      determine, based on at least one of the states within the sequence of states, a process metric associated with the object, the process metric comprising an indication of whether processing requirements for the object are satisfied for individual states in the sequence of states; and
   initiate an adjustment to the processing process based on (1) at least one of the states within the sequence of states and (2) the process metric, the adjustment configured to enhance the process metric for the individual states in the sequence of states such that final processing requirements for the object are satisfied.
49. The apparatus of clause 48, wherein the adjustment comprises a change in a process parameter associated with the illumination source, projection optics, the pattern, and/or the substrate.
50. The apparatus of clause 48 or 49, wherein the processing process is a semiconductor processing process, and
   wherein the processed object is a semiconductor wafer, or one or more portions of the semiconductor wafer.
51. The apparatus of any of clauses 48-50, wherein the process metric comprises yield, and satisfying the processing requirements comprises increasing the yield.
52. The apparatus of any of clauses 48-51, wherein initiating the adjustment comprises optimizing the process metric based on the sequence of states, and determining the adjustment based on the optimized process metric.
53. The apparatus of any of clauses 48-52, wherein the adjustment is an exposure correction associated with the lithography apparatus.
54. The apparatus of any of clauses 48-53, wherein determining the sequence of states, determining the process metric, and initiating the adjustment are performed as at least part of a model free reinforcement learning (MFRL) framework.
55. The apparatus of any of clauses 48-54, wherein the sequence of states includes one or more future states of the object, wherein
   determining the process metric is based on the sequence of states including the one or more future states; and
   initiating the adjustment to the processing process is based on the sequence of states, including the one or more futures states, and the process metric.
56. The apparatus of any of clauses 48-55, wherein the sequence of states corresponds to a sequence of processing operations performed for the object, wherein satisfying the processing requirements comprises enhancing the process metric, and wherein initiating the adjustment comprises:
   determining a policy function, P(s), that defines processing operation corrections for individual states, equipment for performing the processing operations, and/or one or more process parameters for the processing operations; and/or
   determining a value function, V(s), that defines the enhancement of the process metric assuming the policy function is followed until completion of the sequence of processing operations.
57. A semiconductor processing method, the method comprising:
   determining, with one or more physical processors, a sequence of states of a processed object, the states determined based on processing information associated with the object;
   determining, with the one or more processors, based on at least one of the states within the sequence of states, a process metric associated with the object, the process metric indicating a quality of processing for individual states in the sequence of states; and
   initiating, with the one or more processors, an adjustment to a processing process based on (1) at least one of the states within the sequence of states and (2) the process metric, the adjustment configured to enhance the process metric for the individual states in the sequence of states such that final processing requirements meet a quality criterion.

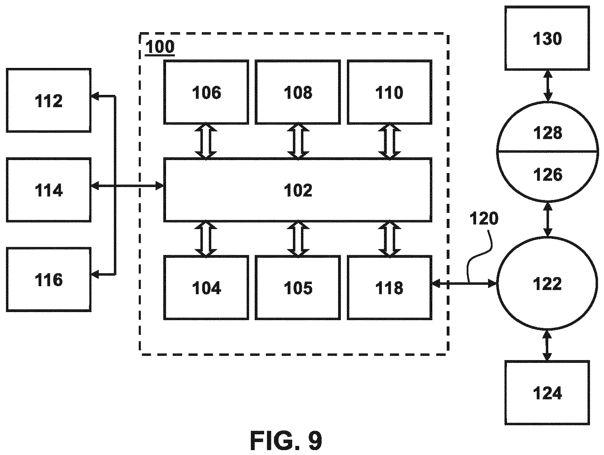

Fig. 9 is a block diagram that illustrates a computer system 100 that can assist in implementing the methods, flows, or the systems disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 may also include a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide all or part of a method described herein, for example. The received code may be executed by processor 104 as it is received, and/or stored in storage device 110, or other non-volatile storage for later execution. In this manner, computer system 100 may obtain application code in the form of a carrier wave.

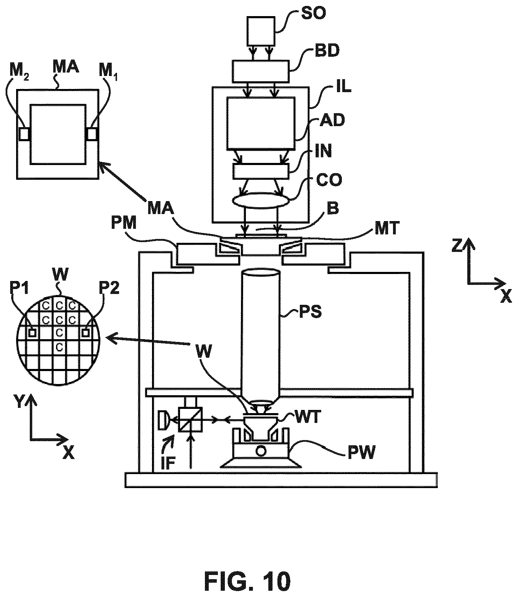

Fig. 10 schematically depicts an exemplary lithographic projection apparatus that may be utilized in conjunction with the techniques described herein. The apparatus comprises:
- an illumination system IL, to condition a beam B of radiation. In this particular case, the illumination system also comprises a radiation source SO;
- a first object table (e.g., patterning device table) MT provided with a patterning device holder to hold a patterning device MA (e.g., a reticle), and connected to a first positioner to accurately position the patterning device with respect to item PS;
- a second object table (substrate table) WT provided with a substrate holder to hold a substrate W (e.g., a resist-coated silicon wafer), and connected to a second positioner to accurately position the substrate with respect to item PS; and
- a projection system ("lens") PS (e.g., a refractive, catoptric or catadioptric optical system) to image an irradiated portion of the patterning device MA onto a target portion C (e.g., comprising one or more dies) of the substrate W.

As depicted herein, the apparatus is of a transmissive type (i.e., has a transmissive patterning device). However, in general, it may also be of a reflective type, for example (with a reflective patterning device). The apparatus may employ a different kind of patterning device relative to classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander Ex, for example. The illuminator IL may comprise adjusting means AD for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

It should be noted with regard to Fig. 10 that the source SO may be within the housing of the lithographic projection apparatus (as is often the case when the source SO is a mercury lamp, for example), but that it may also be remote from the lithographic projection apparatus, the radiation beam that it produces being led into the apparatus (e.g., with the aid of suitable directing mirrors); this latter scenario is often the case when the source SO is an excimer laser (e.g., based on KrF, ArF or F₂ lasing).

The beam PB subsequently intercepts the patterning device MA, which is held on a patterning device table MT. Having traversed the patterning device MA, the beam B passes through the lens PL, which focuses the beam B onto a target portion C of the substrate W. With the aid of the second positioning means (and interferometric measuring means IF), the substrate table WT can be moved accurately, e.g. to position different target portions C in the path of the beam PB. Similarly, the first positioning means can be used to accurately position the patterning device MA with respect to the path of the beam B, e.g., after mechanical retrieval of the patterning device MA from a patterning device library, or during a scan. In general, movement of the object tables MT, WT will be realized with the aid of a long-stroke module (coarse positioning) and a short-stroke module (fine positioning), which are not explicitly depicted in Fig. 10. However, in the case of a stepper (as opposed to a step-and-scan tool) the patterning device table MT may just be connected to a short stroke actuator, or may be fixed.

The depicted tool can be used in two different modes:
- In step mode, the patterning device table MT is kept essentially stationary, and an entire patterning device image is projected in one go (i.e., a single "flash") onto a target portion C. The substrate table WT is then shifted in the x and/or y directions so that a different target portion C can be irradiated by the beam PB;
- In scan mode, essentially the same scenario applies, except that a given target portion C is not exposed in a single "flash". Instead, the patterning device table MT is movable in a given direction (the so-called "scan direction", e.g., the y direction) with a speed v, so that the projection beam B is caused to scan over a patterning device image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

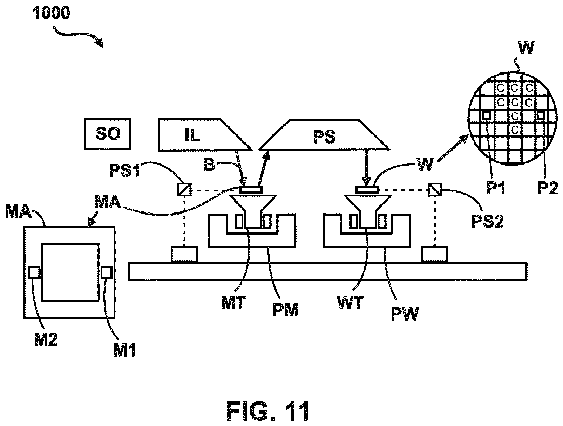

Fig. 11 schematically depicts another exemplary lithographic projection apparatus 1000 that can be utilized in conjunction with the techniques described herein.

The lithographic projection apparatus 1000 comprises:
- a source collector module SO
- an illumination system (illuminator) IL configured to condition a radiation beam B (e.g. EUV radiation).
- a support structure (e.g. a patterning device table) MT constructed to support a patterning device (e.g. a mask or a reticle) MA and connected to a first positioner PM configured to accurately position the patterning device;
- a substrate table (e.g. a wafer table) WT constructed to hold a substrate (e.g. a resist coated wafer) W and connected to a second positioner PW configured to accurately position the substrate; and
- a projection system (e.g. a reflective projection system) PS configured to project a pattern imparted to the radiation beam B by patterning device MA onto a target portion C (e.g. comprising one or more dies) of the substrate W.

As depicted in Fig. 11, the apparatus 1000 is of a reflective type (e.g. employing a reflective patterning device). It is to be noted that because most materials are absorptive within the EUV wavelength range, the patterning device may have multilayer reflectors comprising, for example, a multi-stack of Molybdenum and Silicon. In one example, the multi-stack reflector has 40 layer pairs of Molybdenum and Silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

The illuminator IL receives an extreme ultra violet radiation beam from the source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP") the plasma can be produced by irradiating a fuel, such as a droplet, stream or cluster of material having the line-emitting element, with a laser beam. The source collector module SO may be part of an EUV radiation system including a laser, not shown in Fig. 11, for providing the laser beam exciting the fuel. The resulting plasma emits output radiation, e.g., EUV radiation, which is collected using a radiation collector, disposed in the source collector module. The laser and the source collector module may be separate entities, for example when a CO2 laser is used to provide the laser beam for fuel excitation.

In such cases, the laser is not considered to form part of the lithographic apparatus and the radiation beam is passed from the laser to the source collector module with the aid of a beam delivery system comprising, for example, suitable directing mirrors and/or a beam expander. In other cases the source may be an integral part of the source collector module, for example when the source is a discharge produced plasma EUV generator, often termed as a DPP source. In an embodiment, a DUV laser source may be used.

The illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B is incident on the patterning device (e.g., mask) MA, which is held on the support structure (e.g., patterning device table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of the radiation beam B. Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks PI, P2.

The depicted apparatus 1000 could be used in at least one of the following modes:
In step mode, the support structure (e.g. patterning device table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.

In scan mode, the support structure (e.g. patterning device table) MT and the substrate table WT are scanned synchronously while a pattern imparted to the radiation beam is projected onto a target portion C (i.e. a single dynamic exposure). The velocity and direction of the substrate table WT relative to the support structure (e.g. patterning device table) MT may be determined by the (de-)magnification and image reversal characteristics of the projection system PS.

In another mode, the support structure (e.g. patterning device table) MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

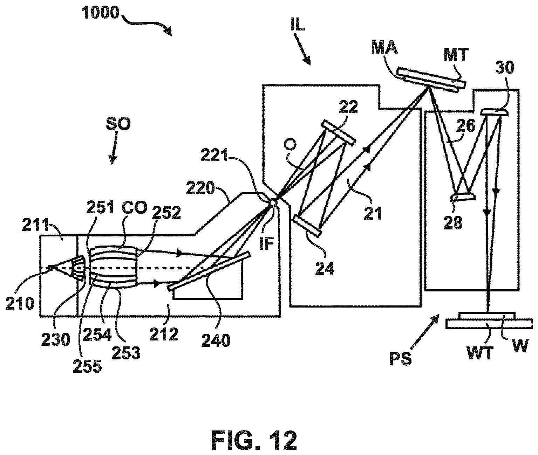

Fig. 12 shows the apparatus 1000 in more detail, including the source collector module SO, the illumination system IL, and the projection system PS. The source collector module SO is constructed and arranged such that a vacuum environment can be maintained in an enclosing structure 220 of the source collector module SO. An EUV radiation emitting plasma 210 may be formed by a discharge produced plasma source. EUV radiation may be produced by a gas or vapor, for example Xe gas, Li vapor or Sn vapor in which the plasma 210 is created to emit radiation in the EUV range of the electromagnetic spectrum. The plasma 210 is created by, for example, an electrical discharge causing at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 further indicated herein at least includes a channel structure, as known in the art.

The collector chamber 212 may include a radiation collector CO which may be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the figures, for example there may be 1- 6 additional reflective elements present in the projection system PS than shown in Fig. 12.

Collector optic CO, as illustrated in Fig. 12, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type may be used in combination with a discharge produced plasma source, often called a DPP source.

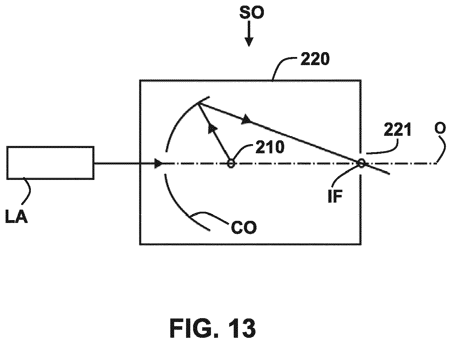

Alternatively, the source collector module SO may be part of an LPP radiation system as shown in Fig. 13. A laser LA is arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

The concepts disclosed herein may simulate or mathematically model any generic imaging system for imaging sub wavelength features, and may be especially useful with emerging imaging technologies capable of producing increasingly shorter wavelengths. Emerging technologies already in use include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range. The concepts disclosed herein may also simulate or mathematically model other semiconductor processing steps.

While the concepts disclosed herein may be used for imaging on a substrate such as a silicon wafer, it shall be understood that the disclosed concepts may be used with any type of lithographic imaging systems, e.g., those used for imaging on substrates other than silicon wafers. In addition, the combination and sub-combinations of disclosed elements may comprise separate embodiments. For example, a model free reinforcement learning system and yield as a process metric may be used together in a single embodiment, or the model free reinforcement learning system may be used separately and/or with another process metric. These features may comprise separate embodiments, and/or these features may be used together in the same embodiment.
The descriptions above are intended to be illustrative, not limiting. Thus, it will be apparent to one skilled in the art that modifications may be made as described without departing from the scope of the claims set out below.

## Claims

1. A semiconductor processing method, the method comprising:
determining, with one or more physical processors, a sequence of states of a processed object, the states determined based on processing information associated with the object;
determining, with the one or more processors, based on at least one of the states within the sequence of states, a process metric associated with the object, the process metric comprising an indication of whether processing requirements for the object are satisfied for individual states in the sequence of states; and
initiating, with the one or more processors, an adjustment to a processing process based on (1) at least one of the states within the sequence of states and (2) the process metric, the adjustment configured to enhance the process metric for the individual states in the sequence of states such that final processing requirements for the object are satisfied.

2. The method of claim 1, wherein the sequence of states corresponds to a sequence of processing operations performed for the object, and wherein determining the sequence of states, determining the process metric, and initiating the adjustment comprises:
determining a policy function, P(s), that defines processing operation corrections for individual states, equipment for performing the processing operations, and/or one or more process parameters for the processing operations; and/or
determining a value function, V(s), that defines the enhancement of the process metric assuming the policy function is followed until completion of the sequence of processing operations.

3. The method of claim 2, wherein the value function defines an expected process metric for a given state (s).

4. The method of any of claims 1-3, wherein the method is performed for a semiconductor processing environment, and the processed object is a semiconductor wafer, or one or more portions of the semiconductor wafer.

5. The method of any of claims 1-4, wherein the process metric comprises a reward, and the one or more processors comprise an agent.

6. The method of any of claims 1-5, wherein the process metric comprises yield, and enhancing the process metric for the individual states in the sequence of states such that final processing requirements for the object are satisfied comprises increasing the yield.

7. The method of any of claims 1-6, wherein initiating the adjustment comprises (1) optimizing the process metric based on the sequence of states, and determining the adjustment based on the optimized process metric; and/or (2) prompting a user to make the adjustment.

8. The method of any of claims 1-7, wherein the sequence of states corresponds to a sequence of processing operations performed for the object, and the adjustment comprises one or more of a change in which processing operations are performed, a change in an order in which the processing operations are performed, or a change in one or more pieces of equipment used to perform one or more of the processing operations.

9. The method of any of claims 1-8, wherein the sequence of states corresponds to a sequence of processing operations performed for the object, and wherein the processing information comprises one or more of values of measurements of the object performed as part of the processing operations, an indication of which processing operations were performed, an indication of an order of the sequence of processing operations, an indication of which equipment was used in the processing operations and/or associated machine constants, or processing parameters of the processing operations.

10. The method of any of claims 1-9, wherein determining the sequence of states, determining the process metric, and initiating the adjustment are performed as at least part of a model free reinforcement learning (MFRL) framework.

11. The method of claim 10, wherein the MFRL framework comprises one or more of an asynchronous advantage actor-critic algorithm, a Q-learning with normalized advantage function, a trust region policy optimization algorithm, a proximal policy optimization algorithm, a twin delayed deep deterministic policy gradient, or a soft actor-critic algorithm.

12. The method of any of claims 1-11, wherein the sequence of states includes one or more future states of the object, wherein
determining the process metric is based on the sequence of states including the one or more future states; and
initiating the adjustment to the processing process is based on the sequence of states, including the one or more futures states, and the process metric.

13. The method of any of claims 2-12, further comprising comparing, with the one or more processors, a first sequence of one or more processing operations having first process parameters to a second sequence of one or more processing operations having second process parameters based on policy functions and value functions associated with the first and second sequences.

14. The method of any of claims 2-13, further comprising performing the determining of the sequence of states, the determining of the process metric, and the initiating of the adjustment as part of a serving operational phase; and/or
prior to the serving phase, training the policy function and the value function during a training operational phase.

15. The method of claim 14, wherein the training operational phase is performed in a simulated semiconductor processing environment.
